# EUROPÄISCHE PATENTSCHRIFT

(11) **EP 2 237 325 B1**
(45) Veröffentlichungstag und Bekanntmachung des Hinweises auf die Patenterteilung: **29.06.2011**
(21) Anmeldenummer: 09015596.1
(22) Anmeldetag: 17.12.2009
(51) Int. Cl.: H01L 31/048

(54) **Photovoltaikmodul**
Photovoltaic module
Module photovoltaïque

(43) Veröffentlichungstag der Anmeldung: 06.10.2010
(73) Patentinhaber: KIOTO Photovoltaics GmbH, 9300 St. Veit (AT)
(72) Erfinder: Eusch, Ingram, 9500 Villach (AT); Frank, Rudolf, 9064 Pischeldorf (AT); Kogler, Armin, 9330 Treibach (AT)
(74) Vertreter: Becker, Thomas

(56) Entgegenhaltungen:
- WO-A1-99/17379
- WO-A1-99/23706
- DE-A1- 4 434 207

## Beschreibung

Die Erfindung betrifft einen Photovoltaik-Modul. Hauptbestandteile eines solchen Solarmoduls mit Solarzellen aus kristallinem Silizium sind eine transparente Abdeckung, Folien, in die die Solarzellen mit ihrer zugehörigen elektrischen Kontaktierung und elektrischen Anschlusselementen eingebettet sind sowie eine der Abdeckung gegenüberliegende Schutzschicht, auch backsheet genannt.

Es ist bekannt, die Abdeckung, die Folien (Klebeschichten) mit dazwischen liegenden Photovoltaik-Zellen sowie die Schutzschicht übereinander anzuordnen und in einem Vakuum-Laminierverfahren zu einer kompakten, lunkerfreien Einheit, dem Photovoltaik-Modul, zu verbinden. Durch die Erwärmung während des Laminiervorgangs (beispielsweise 200° C) werden die genannten Folien viskos, füllen Hohlräume zwischen und um die Photovoltaik-Zellen aus und bilden gleichzeitig die gewünschte Klebeverbindung zwischen Abdeckung und Photovoltaik-Schicht beziehungsweise Photovoltaik-Schicht und Schutzschicht.

Nach dem Laminieren werden randseitig überstehende Folienteile (überstehende Teile der Klebeschicht) sowie der Schutzschicht exakt auf das Maß der transparenten Abdeckung abgeschnitten. Dazu wird ein Messer entlang der Kante der Abdeckung geführt.

Dieses Verfahren hat verschiedene Nachteile:

Während des Wegschneidens überstehender Abschnitte der Folie/Klebeschicht/Schutzschicht kann die Abdeckung randseitig beschädigt werden. Durch diese Beschädigung entstehen unerwünschte Zwickel zwischen den einzelnen Schichten des Moduls, in die später Feuchtigkeit eindringen kann, was insbesondere bei Frost-/Tauwechseln problematisch ist.

Solche Zwickel können sich auch im Übergangsbereich zwischen den einzelnen Schichten randseitig ausbilden. Es entstehen die zuvor genannten Probleme analog.

Die transparente Abdeckung, üblicherweise aus Glas, ist regelmäßig nicht exakt rechteckig. Während zwei gegenüberliegende Seitenkanten meist parallel verlaufen, gilt dies für die verbindenden Seitenkanten nicht. Oft ergibt sich eine trapezartige Geometrie oder eine Rhombus-Grundform.

Beides macht Probleme, wenn der Photovoltaik-Modul anschließend in einen zugehörigen Rahmen eingesetzt wird, der exakt rechteckig ist. Üblicherweise kann dann keine zuverlässige Abdichtung erfolgen.

Aus der DE 44 34 207 A1 ist ein Photovoltaik-Modul bekannt, bei dem eine aus Glas bestehende transparente Abdeckung allseitig von einem Polymerfilm umgeben ist, der mit einem weiteren Polymerfilm verbunden ist, der die Zellen des Photovoltaik-Moduls bedeckt, die auf der transparenten Abdeckung aufgeklebt sind.

Die WO 99/17379 A offenbart einen Photovoltaik-Modul, der auf der der Sonne abgewandten Seite eine Deckschicht aufweist, die um alle vier Ränder des Moduls herumgeführt ist und auch um die der Sonne zugewandte transparente Abdeckung in deren Randbereich.

Der Erfindung liegt die Aufgabe zugrunde, die vorstehend skizzierten Nachteile zu vermeiden.

Dabei liegt der Erfindung die Erkenntnis zugrunde, dass ein wesentliches Problem darin besteht, dass Unregelmäßigkeiten (Unstetigkeiten) bis hin zu Löchern oder Lunkern im Randbereich des Moduls für die geschilderten Probleme verantwortlich sind.

Diese Unstetigkeiten können nach dem Laminieren und Schneiden durch einen separaten Bearbeitungsschritt beseitigt werden, beispielsweise durch eine nachträgliche Versiegelung. Der zusätzliche Verfahrensschritt würde nicht nur die Herstellungszeit verlängern, sondern auch zusätzliche Kosten verursachen.

Der wesentliche Erfindungsgedanke besteht deshalb darin, die genannten Folien (Klebeschichten) selbst zur randseitigen Versiegelung des Moduls zu nutzen.

Wie ausgeführt schmelzen die Folien (Klebefolien) während des Laminiervorgangs auf, werden viskos und füllen dann beispielsweise Abschnitte zwischen benachbarten Photovoltaik-Zellen und/oder Abschnitte um die Photovoltaik-Zellen herum ebenso aus wie etwaige sonstige Hohlräume. Dabei fließt ein Teil des Materials zwangsläufig auch über den umfangsseitigen Randbereich hinaus und dann weiter über den Randbereich insbesondere der transparenten Abdeckung.

Mit anderen Worten: es wird quasi in-situ eine umfangsseitige Beschichtung aus dem Material der Klebeschicht gebildet, die nicht nur die Abdeckung randseitig schützt, sondern auch Anschlussbereiche zur Abdeckung beziehungsweise zur Schutzschicht überdeckt. Umfangsseitig (randseitig) wird demnach eine faktisch monolithische Beschichtung ausgebildet, die, ausgehend von dem Bereich zwischen Schutzschicht und Abdeckung randseitig umläuft und die transparente Abdeckung umfangsseitig überragt.

Der nachfolgende Zuschnitt erfolgt so, dass die Klebeschicht den Modul umlaufend randseitig nur noch um 0,1 bis 3 mm überragt. Mit anderen Worten: entgegen dem Stand der Technik werden überstehende Bereiche der Klebeschicht und/oder Schutzschicht nicht bündig auf das Außenmaß der Abdeckung weggeschnitten, vielmehr verbleibt ein randseitiger Überstand der Klebeschicht(en) und gegebenenfalls der Schutzschicht.

Dieser Überstand schützt die Abdeckung randseitig ebenso wie etwaige Anschlussbereiche der Abdeckung und/oder Schutzschicht zu benachbarten Teilen des Photovoltaik-Moduls zuverlässig.

Der Zuschnitt kann gleichzeitig so erfolgen, dass der fertige Modul eine exakte Rechteckform aufweist, unabhängig von den erwähnten Toleranzen der Abdeckung.

Es ist bekannt, dass die Abdeckung bei einem Grundmaß von beispielsweise 985 x 1.500 mm Maßtoleranzen von +/- 1,5 mm bezüglich Länge und Breite aufweisen kann (beziehungsweise +/- 3,2 mm in der Diagonalen). Daraus berechnet sich ein entsprechender Toleranzfaktor, der erfindungsgemäß durch einen entsprechenden Zuschnitt um mindestens 50 %, ohne weiteres aber auch um mindestens 90 % verbessert werden kann, das heißt auf Toleranzen bezüglich der genannten Grundmaße von beispielsweise +/-0,2 mm (Länge, Breite).

Der entsprechende Zuschnitt wird erleichtert, wenn die Abdeckung mindestens drei, bei einer rechteckigen Abdeckung üblicherweise vier definierte Markierungen aufweist, die vor dem Zuschnitt optisch erfasst werden, um einen weitestgehend rechteckigen Zuschnitt zu ermöglichen. Diese Markierungen können Punkte, Kreuze oder Winkel im Eckbereich der Abdeckung sein und verbleiben dort, weshalb sie optisch unauffällig in Größe und Farbgebung gestaltet sein sollten.

Nach einer Ausführungsform erstreckt sich die erste Klebeschicht durchlaufend bis über korrespondierende Randabschnitte der Abdeckung. Analog kann dies für die zweite Klebeschicht gelten.

Der Überstand beträgt nach einer Ausführungsform umlaufend randseitig maximal 1 mm und nach einer anderen Ausführungsform mindestens 0,2 mm.

Wie bereits erwähnt kann die Klebeschicht von einer Klebefolie gebildet werden, beispielsweise einer Klebefolie aus vernetztem Ethylen-Vinyl-Acetat (EVA). Solche Folien beziehungsweise Klebeschichten sind Stand der Technik bei Solarmodulen.

Dies gilt auch für die Schutzschicht (Backsheet) aus einer Verbundfolie, beispielsweise auf Basis Polyvinylfluorid (PVF). Eine solche Folie weist eine relativ hohe Stabilität und Reflektivität auf. Sie ist gleichzeitig wetterfest und UV-beständig.

Während die Folien beziehungsweise die daraus gebildeten Klebeschichten üblicherweise eine Dicke, senkrecht zur Abdeckung, von 0,1 bis 1,0 mm aufweisen und dies auch für die Dicke der Schutzschicht gilt, hat sich eine Materialstärke von 0,2 bis 0,8 mm für die Klebefolien und von 0,2 bis 0,7 mm für die Schutzfolie als ausreichend erwiesen, wobei die Photovoltaik-Zellen üblicherweise eine Dicke bis maximal 0,2 mm besitzen, so dass bei den genannten Folienstärken sichergestellt ist, dass diese auch Hohlräume zwischen und neben den Zellen während des Laminiervorgangs ausfüllen können.

Weitere Merkmale der Erfindung ergeben sich aus den Merkmalen der Unteransprüche sowie den sonstigen Anmeldungsunterlagen.

Die Erfindung wird nachstehend anhand eines Ausführungsbeispieles näher beschrieben. Dabei zeigen-jeweils in stark schematisierter Darstellung -
- Figur 1:: die Zusammenstellung von Abdeckung, Folien und Schutzschicht sowie Photovoltaik-Zellen vor dem Laminiervorgang
- Figur 2:: die Zusammenstellung von Abdeckung, Folien und Schutzschicht sowie Photovoltaik-Zellen nach dem Laminiervorgang
- Figur 3:: eine Aufsicht auf den Modul gemäß Figur 2 (von unten).

In den Figuren sind gleiche oder gleich wirkende Bauteile mit gleichen Bezugsziffern dargestellt.

Zur Herstellung eines Photovoltaik-Moduls wird wie folgt vorgegangen:

Auf eine transparente Abdeckung 10, hier: aus Glas, wird eine EVA-Folie 12 aufgelegt, auf die EVA-Folie 12 werden die Photovoltaik-Zellen 14 (die jeweils zu einem String zusammengeschaltet sind) aufgelegt, darauf wiederum eine zweite EVA-Folie 16 und darauf schließlich eine Schutzschicht 18 aus Polyvinylfluorid.

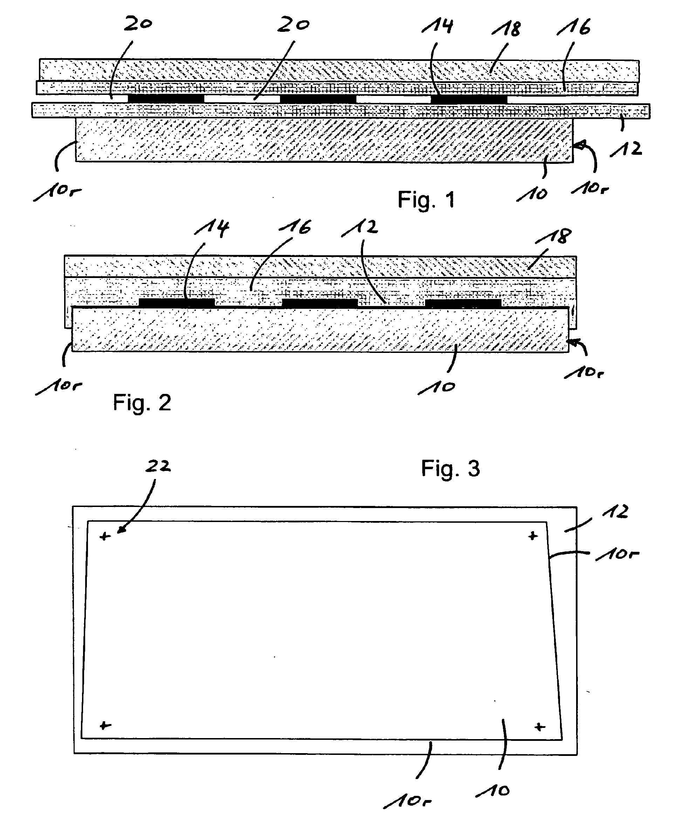

Figur 1 zeigt, dass die Folien 12, 16 sowie die Schutzschicht 18 die Abdeckung 10 (allseitig) randseitig überragen. Figur 1 zeigt auch, dass zwischen benachbarten Zellen 14 beziehungsweise um die Zellen 14 herum Bereiche 20 vorhanden sind, die Hohlräume bilden.

In einer Vakuum-Laminieranlage werden die Folien 12, 16 bei ca. 150° C viskos und fließen in die Bereiche 20 hinein und über den Randbereich 10r der Abdeckung 10. Das Folienmaterial härtet aus, sobald die maximale Temperatur in der Laminieranlage wieder auf Umgebungstemperatur zurückgefahren wird.

In einer nachfolgenden Schneidstation erfolgt der Zuschnitt des Photovoltaik-Moduls derart, dass die Klebeschichten, die aus den Folien 12, 16 gebildet wurden, geringfügig über den Rand 10r der Abdeckung 10 überstehen, und zwar hier: um 0,2 mm, wie schematisch in Figur 2 dargestellt.

Der in Figur 2 in einem Vertikalschnitt dargestellte Photovoltaik-Modul weist eine mehr oder weniger exakte äußere Rechteck-Geometrie auf, wie sich auch aus der Aufsicht gemäß Figur 3 ergibt, wobei die Abdeckung 10 selbst eine (in Figur 3 übertrieben dargestellte) Trapez-Form besitzt, die aber durch einen entsprechenden Zuschnitt der Überstände der Folien 12, 16 und der Schutzschicht 18 kompensiert wurde.

Zu diesem Zweck weist die Abdeckung 10 aus Glas vier kreuzförmige Markierungen 22 auf, und zwar in Eckbereichen der Abdeckung 10, wobei diese Markierungen 22 der Schneidstation die Position der Abdeckung 10 vorgeben, damit diese anschließend exakt auf Maß zugeschnitten werden kann.

Aus der Trapez-Geometrie der Abdeckung 10 folgt zwangsläufig, dass der Überstand 12u der Klebeschicht 12 (Klebefolie 12) nicht allseitig gleich ist. Dies wird aber nicht nur in Kauf genommen, sondern ist ausdrücklich gewünscht, damit der Modul insgesamt eine Rechteckform erhält und dann exakt passend in einen zugehörigen Rahmen eingebaut werden kann.

## Patentansprüche

1. Photovoltaik-Modul mit
1.1 einer transparenten Abdeckung (10), die eine erste Haupt-Oberfläche des Moduls bildet,
1.2einer Schutzschicht (18), die parallel und im Abstand zur Abdeckung (10) verläuft und eine zweite Haupt-Oberfläche des Moduls bildet,
1.3einer ersten Klebeschicht (12) zwischen der Abdeckung (10) und einer aus mehreren Zellen (14) gebildeten Photovoltaik-Schicht,
1.4einer zweiten Klebeschicht (16) zwischen der Schutzschicht (18) und der Photovoltaik-Schicht, wobei
1.5sich die erste und zweite Klebeschicht (12, 16) auch in einen Bereich (20) zwischen die Zellen (14) der Photovoltaik-Schicht und um die Zellen (14) herum erstrecken und über den Rand der Abdeckung (10) des Moduls umlaufend um 0,1-3mm überstehen.

2. Photovoltaik-Modul nach Anspruch 1, bei dem sich mindestens die erste Klebeschicht (12) durchlaufend bis über einen korrespondierenden Randabschnitt (10r) der Abdeckung (10) hinaus erstreckt.

3. Photovoltaik-Modul nach Anspruch 1, bei dem die erste und zweite Klebeschicht (12, 16) den Rand der Abdeckung (10) umlaufend um maximal 1 mm überragen.

4. Photovoltaik-Modul nach Anspruch 1, bei dem die erste und zweite Klebeschicht (12, 16) den Rand der Abdeckung (10) umlaufend um mindestens 0,2 mm überragen.

5. Photovoltaik-Modul nach Anspruch 1, bei dem mindestens eine Klebeschicht (12, 16) von einer Klebefolie gebildet wird.

6. Photovoltaik-Modul nach Anspruch 5, bei dem mindestens eine Klebefolie (12, 16) aus vernetztem Ethylen-Vinyl-Acetat besteht.

7. Photovoltaik-Modul nach Anspruch 1, bei dem mindestens eine Klebeschicht (12, 16) eine Dicke, senkrecht zur Abdeckung (10), von 0,1 bis 1,0mm hat.

8. Photovoltaik-Modul nach Anspruch 1, bei dem die Schutzschicht (18) eine Dicke, senkrecht zur Abdeckung (10), von 0,1 bis 1,0mm hat.

9. Photovoltaik-Modul nach Anspruch 1, bei dem die Schutzschicht (18) aus einer Verbundfolie besteht.

10. Photovoltaik-Modul nach Anspruch 1, bei dem die Abdeckung (10) aus Glas besteht.

11. Photovoltaik-Modul nach Anspruch 1, bei dem die Abdeckung (10) mindestens drei, in definiertem Abstand zueinander stehende Markierungen (22) aufweist.

12. Photovoltaik-Modul nach Anspruch 1, bei dem die Abdeckung (10) vier Markierungen (22) aufweist, die Ecken eines fiktiven Rechtecks bilden.

## Claims

1. The photovoltaic module with
1.1 a transparent cover (10), that forms a first main surface of the module,
1.2 a protective layer (18), that runs parallel and with a distance to the cover (10) and forms a second main surface of the module,
1.3 a first adhesive layer (12) between the cover (10) and a photovoltaic layer formed from a multitude of cells (14),
1.4 a second adhesive layer (16) between the protective layer (18) and the photovoltaic layer, wherein
1.5 the first and second adhesive layer (12, 16) extend into an area (20) between the cells (14) of the photovoltaic layer and around the cells (14) and are projecting the edge of the cover (10) of the module circumferentially by 0,1 - 3 mm.

2. The photovoltaic module according to claim 1, wherein at least the first adhesive layer (12) extends continuously until projecting corresponding edge areas (10r) of the cover (10).

3. The photovoltaic module according to claim 1, wherein the first and the second adhesive layer (12, 16) are projecting the edge of the cover (10) by not more than 1 mm.

4. The photovoltaic module according to claim 1, wherein the first and the second adhesive layer (12, 16) are projecting the edge of the cover (10) by at least 0,2 mm.

5. The photovoltaic module according to claim 1, wherein at least one adhesive layer (12, 16) is formed from an adhesive foil.

6. The photovoltaic module according to claim 5, wherein at least one adhesive foil (12, 16) consists of cross-linked ethylene-vinylacetate.

7. The photovoltaic module according to claim 1, wherein at least one adhesive layer (12, 16) has a thickness, perpendicular to the cover (10), of 0,1 to 1,0 mm.

8. The photovoltaic module according to claim 1, wherein the protective layer (18) has a thickness, perpendicular to the cover (10), of 0,1 to 1,0 mm.

9. The photovoltaic module according to claim 1, wherein the protective layer (18) is made of a composite foil.

10. The photovoltaic module according to claim 1, wherein the cover (10) is made of glass.

11. The photovoltaic module according to claim 1, wherein the cover (10) has at least three markings (22) at a defined distance to each other.

12. The photovoltaic module according to claim 1, wherein the cover (10) has four markings (22), which form the corners of a fictitious rectangle.

## Revendications

1. Module photovoltaïque comportant :
1.1 un couvercle transparent (10), qui forme une première surface supérieure du module,
1.2 une couche de protection (18), qui s'étend parallèlement et à distance du couvercle (10) et forme une deuxième surface supérieure du module,
1.3 une première couche adhésive (12) entre le couvercle (10) et une couche photovoltaïque formée de plusieurs cellules (14),
1.4 une deuxième couche adhésive (16) entre la couche de protection (18) et la couche photovoltaïque, dans lequel
1.5 la première et la deuxième couches adhésives (12,16) s'étendent dans une zone (20) entre les cellules (14) de la couche photovoltaïque et autour des cellules (14) et dépassent de 0.1-3 mm périphériquement par-dessus le bord du couvercle (10) du module.

2. Module photovoltaïque selon la revendication 1, dans lequel au moins la première couche adhésive (12) s'étend en continu jusque au dessus d'une portion de bord (10r) correspondante du couvercle (10).

3. Module photovoltaïque selon la revendication 1, dans lequel la première et la deuxième couches adhésives (12,16) surplombent périphériquement d'au maximum 1mm le bord du couvercle (10).

4. Module photovoltaïque selon la revendication 1, dans lequel la première et la deuxième couches adhésives (12,16) surplombent périphériquement d'au moins 0,2 mm le bord du couvercle (10).

5. Module photovoltaïque selon la revendication 1, dans lequel au moins une couche adhésive (12,16) est formée par un film adhésif.

6. Module photovoltaïque selon la revendication 5, dans lequel au moins un film adhésif (12,16) est constitué d'éthylène-acétate de vinyle réticulé.

7. Module photovoltaïque selon la revendication 1, dans lequel au moins une couche adhésive (12,16) possède une épaisseur, perpendiculairement au couvercle (10), de 0,1 à 1.0 mm.

8. Module photovoltaïque selon la revendication 1, dans lequel la couche de protection (18) possède une épaisseur, perpendiculairement au couvercle (10), de 0,1 à 1.0 mm.

9. Module photovoltaïque selon la revendication 1, dans lequel la couche de protection (18) est constituée d'un film composite.

10. Module photovoltaïque selon la revendication 1, dans lequel le couvercle (10) est constitué de verre.

11. Module photovoltaïque selon la revendication 1, dans lequel le couvercle (10) présente au moins trois marquages (22), disposés à un espacement défini les uns des autres.

12. Module photovoltaïque selon la revendication 1, dans lequel le couvercle (10) présente quatre marquages (22), qui forment les coins d'un rectangle fictif.
